# EUROPEAN PATENT SPECIFICATION

(11) **EP 1 624 485 B1**
(45) Date of publication and mention of the grant of the patent: **21.05.2008**
(21) Application number: 05077308.4
(22) Date of filing: 09.03.1999
(51) Int. Cl.: H01L 27/00, H01L 51/40, H05B 33/10

(54) **Method for manufacturing organic el display device**
Verfahren zur Herstellung einer organischen Elektrolumineszenzanzeige
Procédé de fabrication d'un dispositif organique électroluminescent

(30) Priority: 09.03.1998 JP 5721498
(43) Date of publication of application: 08.02.2006
(62) Divisional of application: 99939247.5
(73) Proprietor: Seiko Epson Corporation, Shinjuku-ku Tokyo 163-0811 (JP); MINNESOTA MINING AND MANUFACTURING COMPANY, Saint Paul, Minnesota 55133-3427 (US)
(72) Inventor: Kobayashi, Hidekazu, Suwa-shi Nagano-ken 392-8502 (JP); Shimoda, Tatsuya, Suwa-shi Nagano-ken 392-8502 (JP); Kiguchi, Hiroshi, Suwa-shi Nagano-ken 392-8502 (JP)
(74) Representative: Kenyon, Sarah Elizabeth

(56) References cited:
- EP-A2- 0 795 421
- WO-A-98/03346

## Description

### TECHNICAL FIELD

The present invention relates to a method for manufacturing an organic EL display device which is used in emissive simple matrix drive-type medium or large volume monochromatic or color displays, camcorder or digital camera view finders, and the like.

### BACKGROUND ART

The difficulty of cathode patterning in simple matrix organic EL displays has been pointed out in the past. This is because the organic layer under the cathode is readily penetrated by solvent. Cathode patterning techniques have thus far been developed to remedy such problems. Examples include the method for RGB 3-color distribution using physical masks as indicated in Japanese Patent Laid-open No.08-227276, and the method for the creation of cathode partition walls for simultaneous cathode patterning during cathode deposition as indicated in US Patent 5,294,869.

As noted on page 913 of the 51^{st} issue (September 21, 1987) of *Applied Physics Letters,* the structure of most conventional organic EL elements comprises a transparent electrode formed on a glass substrate, where light is transmitted through the glass substrate.

However, high precision fineness and positional alignment are difficult to achieve in methods featuring the use of a physical mask. In addition, the process is complicated in cases of separate cathode walls because an etching process is used to form the separate cathode walls.

Furthermore, the penetration through the glass substrate results in outgoing radiation, and thus in greater light leakage in the direction of the substrate plane, allowing only 20% of the total light emission to be used.

### DISCLOSURE OF THE INVENTION

An object of the present invention is to provide a method for the extremely simple patterning of electrodes and light emitting layers in methods for manufacturing organic EL display devices, and to provide such a method in which all the light emission is radiated outward in the direction of the visual field without being wasted.

Means 1 for solving the problem: The method for manufacturing an organic EL display device in the present invention is a method for manufacturing an organic EL display device which is used in simple matrix drives, characterized in that a light-heat conversion layer and heat-propagating layer are formed on a film, a cathode layer is then formed, a light emitting layer is then formed thereon, a positive hole-injecting layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the aforementioned multiple layers have been transferred, and a sealing process is carried out. This structure allows cathodes which are extremely unstable and difficult to pattern to be readily patterned simultaneously with the transfer of the organic EL layer by laser.

Means 2 for solving the problem: The method for manufacturing an organic EL display device in the present invention is a method for manufacturing an organic EL display device which is used in simple matrix drives, characterized in that a light-heat conversion layer and heat-propagating layer are formed on a film, a cathode layer is then formed, an electroluminescent adhesive layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the multiple layers have been transferred, and a sealing process is carried out. This structure allows cathodes with a simple structure, which are extremely unstable and difficult to pattern, to be readily patterned simultaneously with the transfer of the organic EL layer by laser.

Means 3 for solving the problem: This is characterized in that an electron-injecting layer is formed between the cathode layer and light emitting layer of the first means for solving the problem or between the cathode layer and the electroluminescent adhesive layer of the second means for solving the problem. This allows the luminous efficiency to be improved in the aforementioned structures.

Means 4 for solving the problem: The method for manufacturing an organic EL display device that is used in simple matrix drives is characterized in that a light-heat conversion layer and heat-propagating layer are formed on a film, an anode layer is then formed, a positive hole-injecting layer is then formed thereon, a light emitting layer is then formed thereon, an electron-injecting adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out. This structure allows cathodes which are difficult to pattern to be readily patterned by means of a laser or the like after being formed on a glass substrate, and also allows anodes to be patterned simultaneously during the subsequent transfer of the organic EL layer. This structure also allows light to be directly transmitted to the outside without passing through the glass substrate from the organic light emitting layer, so that no light is lost, resulting in better brightness.

Means 5 for solving the problem: The method for manufacturing an organic EL display device that is used in simple matrix drives is characterized in that a light-heat conversion layer and heat-propagating layer are formed on a film, an anode layer is then formed, a positive hole-injecting layer is then formed thereon, an electroluminescent adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out.

This structure allows cathodes which are difficult to pattern to be readily patterned by means of a laser or the like after being formed on a glass substrate, and also allows anodes to be patterned simultaneously during the subsequent transfer of the organic EL layer. The manufacturing process is also simplified because the adhesive layer also has a light-emitting function. This structure also allows light to be directly transmitted to the outside without passing through the glass substrate from the organic light emitting layer, so that no light is lost, resulting in better brightness.

Means 6 for solving the problem: This is characterized in that the aforementioned light emitting layer or electroluminescent adhesive layer is formed by applying luminescent substances emitting different-colored light by means of an ink jet head. This means al different-colored light emitting layers to be readily formed on the film, thereby allowing a colored simple matrix display to be produced with extreme ease.

Means 7 for solving the problem: This is characterized in that means for ink separation between color regions is implemented before said light emitting layer or electroluminescent adhesive layer is applied by an ink jet head. This allows the light emitting layer to be formed in the form of stripes without staining adjacent picture elements

### BRIEF DESCRIPTION OF THE DRAWINGS

Fig. 1 is a cross section illustrating a step for manufacturing the organic EL display device in Embodiment 1.
Fig. 2 is a cross section illustrating a step for manufacturing the organic EL display device in Embodiment 1.
Fig. 3 is a cross section illustrating a step for manufacturing the organic EL display device in Embodiment 1.
Fig. 4 is a cross section illustrating a step for manufacturing the organic EL display device in Embodiment 1.
Fig. 5 is a cross section illustrating a step for manufacturing the organic EL display device in Embodiment 1.
Fig. 6 is a cross section illustrating a step for manufacturing the organic EL display device in Embodiment 1.
Fig. 7 is a cross section illustrating a step for manufacturing the organic EL display device in Embodiment 1.
Fig. 8 is a cross section of the organic EL display device in Embodiment 3.
Fig. 9 is a cross section illustrating a step for manufacturing the organic EL display device in Embodiment 4.
Fig. 10 is a cross section illustrating a step for manufacturing the organic EL display device in Embodiment 4.
Fig. 11 is a cross section illustrating a step for manufacturing the organic EL display device in Embodiment 4.
Fig. 12 is a cross section illustrating a step for manufacturing the organic EL display device in Embodiment 4.
Fig. 13 is a cross section illustrating a step for manufacturing the organic EL display device in Embodiment 4.
Fig. 14 is a cross section illustrating a step for manufacturing the organic EL display device in Embodiment 4.
Fig. 15 is a cross section illustrating a step for manufacturing the organic EL display device in Embodiment 4.
Fig. 16 is a cross section illustrating a step for manufacturing the organic EL display device in Embodiment 4.
Fig. 17 is a cross section illustrating a step for manufacturing the organic EL display device in Embodiment 4.
Fig. 18 is a cross section illustrating a step for manufacturing the organic EL display device in Embodiment 4.
Fig. 19 is a cross section illustrating a step for manufacturing the organic EL display device in Embodiment 5.
Fig. 20 is a cross section illustrating a step for manufacturing the organic EL display device in Embodiment 5.
Fig. 21 is a cross section illustrating a step for manufacturing the organic EL display device in Embodiment 5.
Fig. 22 is a cross section illustrating a step for manufacturing the organic EL display device in Embodiment 5.
Fig. 23 is a cross section illustrating a step for manufacturing the organic EL display device in Embodiment 5.
Fig. 24 is a cross section illustrating a step for manufacturing the organic EL display device in Embodiment 5.
Fig. 25 is a cross section illustrating a step for manufacturing the organic EL display device in Embodiment 5.
Fig. 26 is a cross section illustrating a step for manufacturing the organic EL display device in Embodiment 5.

### BEST MODE FOR CARRYING OUT THE INVENTION

### Embodiment 1

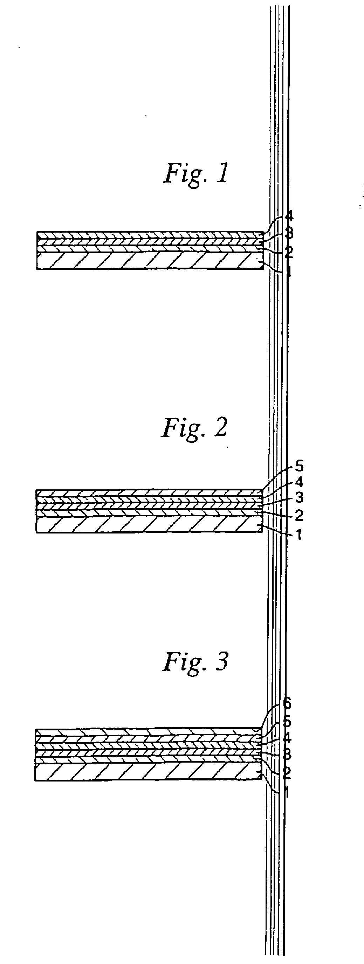

This embodiment is an example of a method for manufacturing an organic EL display device that is used in simple matrix drives, wherein a light-heat conversion layer and heat-propagating layer are formed on a film, a cathode layer is then formed, a light emitting layer is then formed thereon, a positive hole-injecting layer is then formed thereon, the film on which these multiple layers have been formed is then placed in contact with a substrate with a stripe-patterned ITO, the aforementioned multiple layers are transferred onto the substrate by irradia ting the other side of the film with a laser in such a way as to form the shape of the cathode, the film is then removed, a drive mechanism is connected to the substrate onto which the aforementioned multiple layers have been transferred, and a sealing process is carried out. Figs. 1 through 6 are simple cross sections depicting the method for manufacturing the organic EL display device in the present invention.

First, a thermosetting epoxy resin in which carbon particles had been mixed was coated to a thickness of 5 microns and cured at room temperature as a layer 2 for converting laser light to heat on a base film 1 comprising a 0.1 mm thick polyethylene terephthalate film. Then, a poly- - methylstyrene film was formed when coated to a thickness of 1 micron as a heat propagating and release layer 3, and aluminum:lithium (10:1) was deposited to a thickness of 200 nm as a cathode layer 4 on the surface (Fig. 1).

Alq3 was then deposited to a thickness of 70 nm as the light emitting layer (Fig. 2).

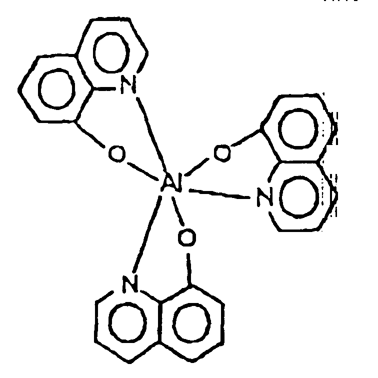

A mixture of NPD and polyvinyl carbazol was then dissolved in solvent, and was coated and dried to a thickness of 60 nm as the positive hole-injecting adhesive layer 6 (Fig. 3).

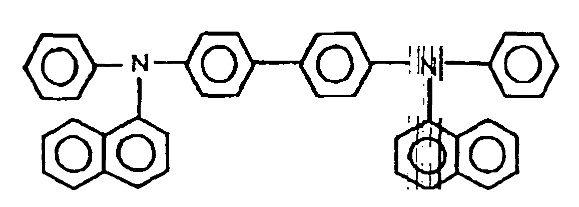

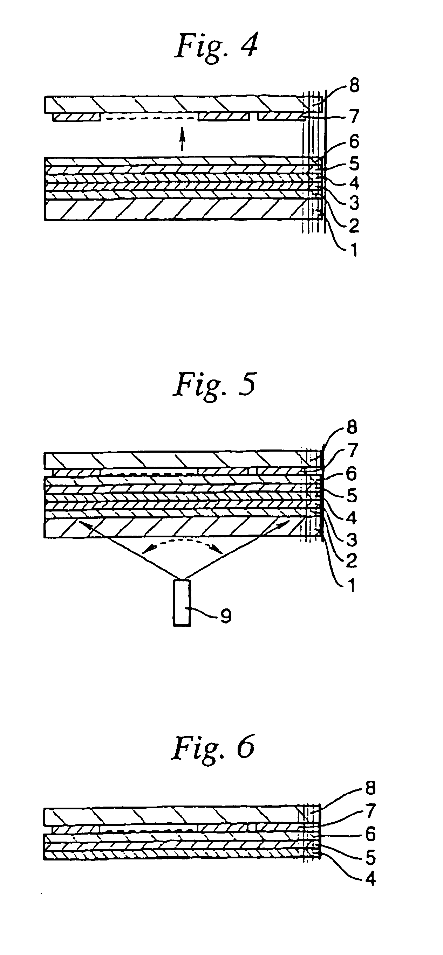

The resulting film was then placed in contact with a transparent glass substrate 8 with a patterned ITO having 256 stripes (Fig. 4).

A pattern of 64 stripes was then produced with a 13 W YAG laser 9 on the film side so as to intersect the striped pattern of the ITO (Fig. 5).

The film was then removed, giving an organic EL substrate with 256 x 64 picture elements having the structure depicted in Fig. 6.

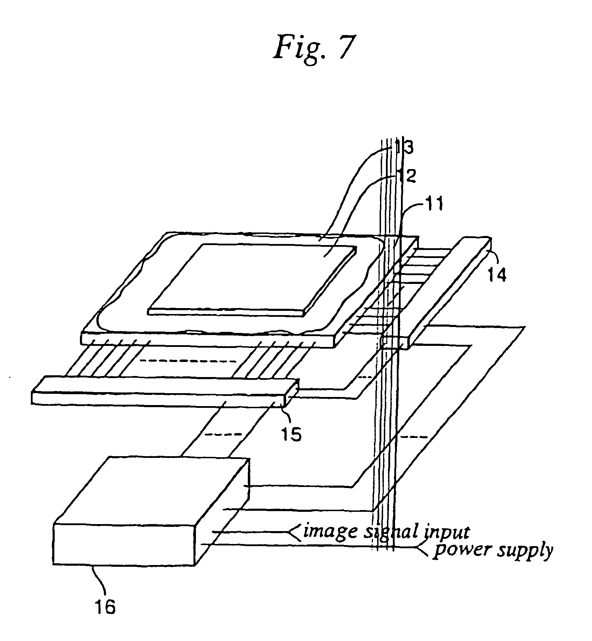

Drivers 14 and 15 and a controller 16 were then connected to the organic EL substrate 11, as shown in Fig. 7, a transparent protective substrate was placed in contact with UV setting sealant 13, and the protective substrate was cured and sealed by irradiation with UV rays. Moving image display could thus be achieved with the input of drive power and signals to the display device thus obtained.

General resins such as polycarbonates and polyether sulfones can also be used in addition to polyesters as the transfer film used in this embodiment.

Any material that can efficiently convert laser light to heat may similarly be used in addition to carbon-kneaded resins as the material for the light-heat conversion layer used in this embodiment.

Any low melting point (preferably around 100°C) material capable of withstanding the production of heat during the formation of the electrodes can similarly be used in addition to those indicated here as the heat propagating layer used in this embodiment.

Aluminum, lithium, magnesium, calcium, alloys thereof, halogenated compounds, and the like can be used as the material for forming the cathode in this embodiment.

Metal complexes such as quinoline, metal complexes such as azomethine, conjugated low molecule weight species and conjugated high molecular weight species, or any other such organic EL materials can be used as the light-emitting material used in this embodiment. The method for forming the film is not limited to deposition. The film can also be formed when the material is coated after being dissolved in a solvent.

In terms of the light emitting layer and anode, any material capable of injecting positive holes into the light emitting layer, such as triphenylamine derivatives, porphin compounds, polyaniline and its derivatives, and polythiophene and its derivatives, can be used in addition to NPD as the positive hole-injecting material used in this embodiment.

Any resin that does not hamper positive hole injection, that can be melted by heat from laser light, and that has excellent adhesion on ITO and glass can be used as the material used for the adhesive layer in this embodiment.

Thermosetting resins other than UV setting resin can similarly be used as the sealant used in this embodiment.

### Embodiment 2

This embodiment is an example of a method for manufacturing an organic EL display device that is used in simple matrix drives, wherein a light-heat conversion layer and heat-propagating layer are formed on a film, a cathode layer is then formed, an electroluminescent adhesive layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the multiple layers have been transferred, and a sealing process is carried out.

A light-heat conversion layer and heat propagating layer cathode were first formed on a base film in the same manner as in the first embodiment, and MEH-PPV was then made into a film in the form of a chloroform solution and dried to a thickness of 70 nm as the electroluminescent adhesive layer.

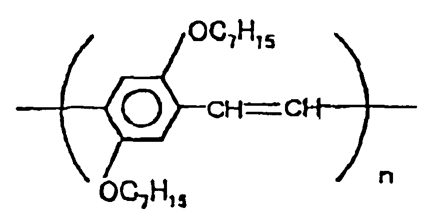

The resulting film was then placed in contact with a transparent glass substrate with a patterned ITO in the same manner as in the first embodiment, and a driver circuit was mounted and sealed, giving an organic EL display device.

Moving image display could thus be achieved with the input of drive power and signals to the display device thus obtained.

### Embodiment 3

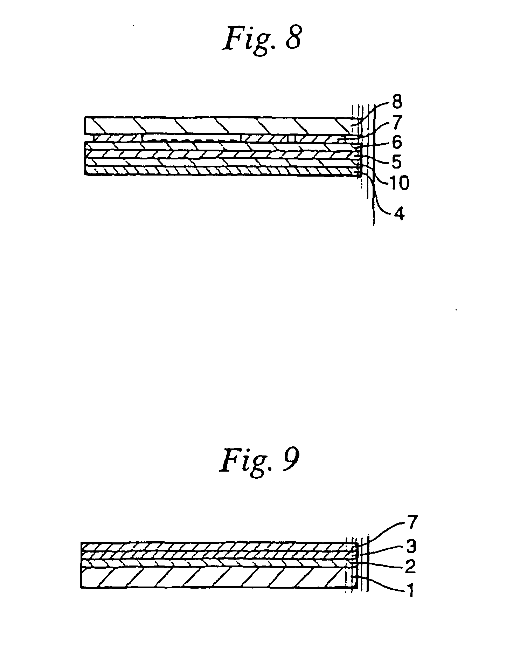

This embodiment is an example of an electron-injecting layer formed between the cathode and light emitting layer in the first embodiment. Fig. 8 is a simple cross section of the organic EL display device in this embodiment. After the cathode in Embodiment 1 had been formed, Znq2 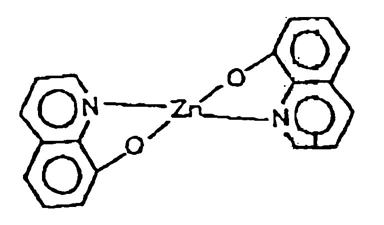 was deposited to a thickness of 20 nm as an electron-injecting layer 10. The light emitting layer and other layers thereafter were then formed in the same manner as in Embodiment 1, giving an organic EL display device.

The organic EL display device in Embodiment 1 had a luminous efficiency of 21 m/W, whereas this embodiment had a luminous efficiency of 2.51 m/W.

In terms of the light emitting layer and anode, any material capable of positive hole injection, such as polyphenylene vinylene derivatives, organometal complexes such as Alq3, and the like, can be used in addition to NPD as the electron-injecting material used in this embodiment. Any method that does not penetrate the cathode can be used as the method for forming the film.

This embodiment can similarly be used in Embodiment 2.

### Embodiment 4

This embodiment is an example of a method for manufacturing an organic EL display device that is used in simple matrix drives, wherein a light-heat conversion layer and heat-propagating layer are formed on a film, an anode layer is then formed, a positive hole-injecting layer is then formed thereon, a light emitting layer is then formed thereon, an electron-injecting adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out. Figs. 9 through 14 are simple cross sections depicting the method for manufacturing the organic EL display device in the present invention.

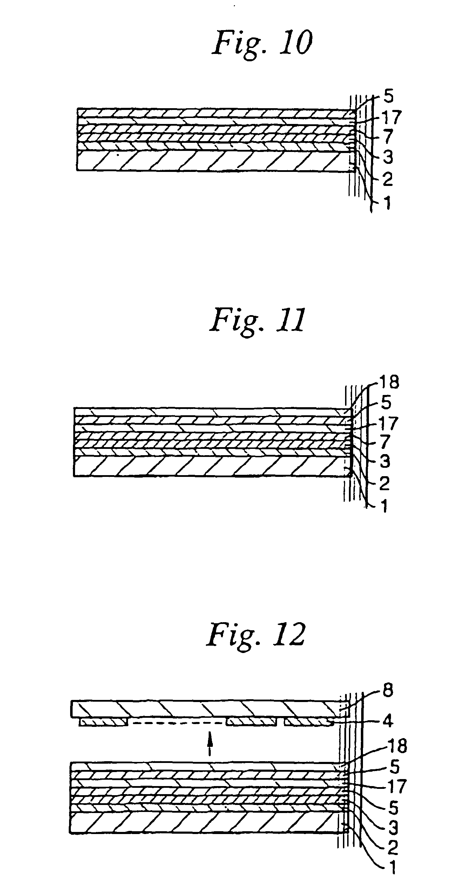

First, the light-heat conversion layer 2 and heat propagating layer 3 given in Embodiment 1 were formed on a base film 1 comprising a 1 mm thick polycarbonate film, and indium tin oxide was formed by sputtering to a thickness of 200 nm as an anode layer 7 (Fig. 9). 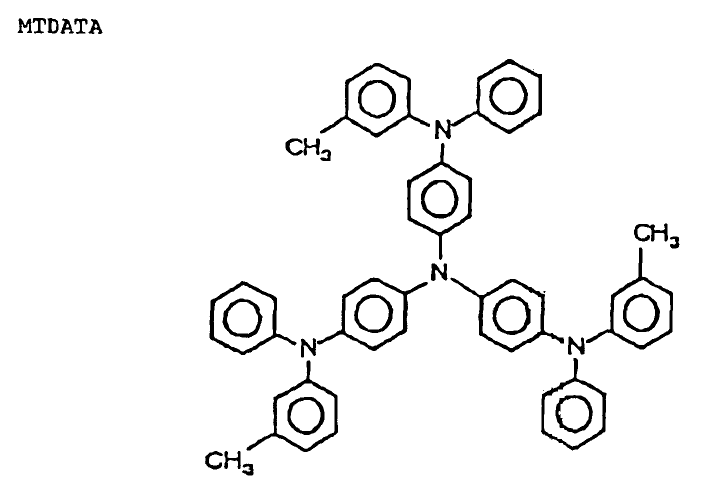 was then deposited to a thickness of 15 nm as the positive hole-injecting layer 17, and NPD was then deposited to a thickness of 20 nm. Alq3 was then deposited to a thickness of 70 nm as the light emitting layer 5 (Fig. 10).

A chloroform solution of PPV was then applied to a thickness of 60 nm as an electron-injecting adhesive layer 18 (Fig. 11).

The resulting film was then placed in contact with a transparent glass substrate having an aluminum and lithium alloy cathode patterned with 256 stripes by laser (Fig. 12).

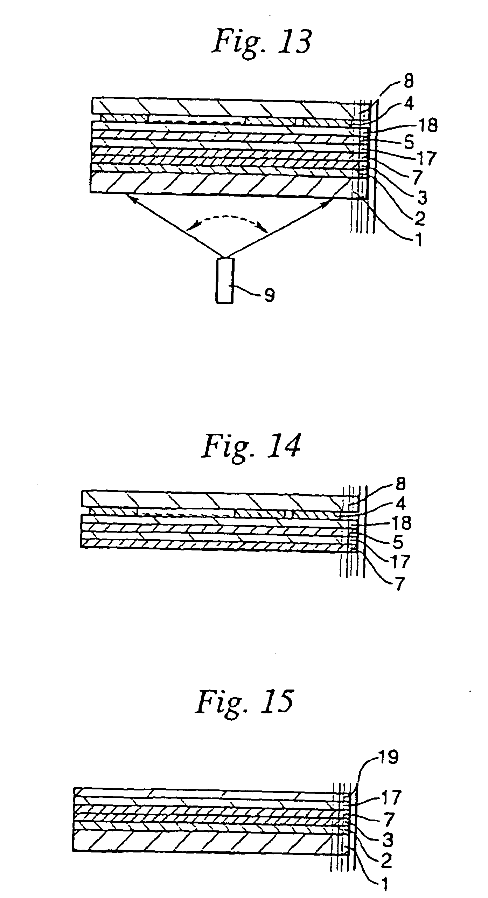

A pattern of 64 stripes was then produced with W YAG laser 9 on the film side so as to intersect the striped pattern of the ITO (Fig. 13).

The film was then removed, giving the organic EL substrate with 256 x 64 picture elements having the structure depicted in Fig. 14.

Drivers and a controller were then connected to the organic EL substrate, as shown in Fig. 7, a transparent protective substrate was placed in contact with an epoxy thermosetting sealant, and the protective substrate was cured and sealed at room temperature. Moving image display could thus be achieved with the input of drive power and signals to the display device thus obtained. The luminous efficiency was 31 m/W.

The same materials and methods given in Embodiment 1 can be used in this embodiment as well.

### Embodiment 5

This embodiment is an example of a method for manufacturing an organic EL display device that is used in simple matrix drives, wherein a light-heat conversion layer and heat-propagating layer are formed on a film, an anode layer is then formed, a positive hole-injecting layer is then formed thereon, an electroluminescent adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out.

Figs. 15 through 18 are simple cross sections depicting the method for manufacturing the organic EL display device in the present invention. An anode and positive hole-injecting layer were formed on a base film in the same manner as in Embodiment 3. A chloroform solution of PPV 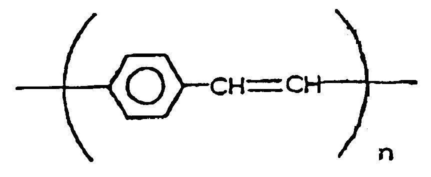 was then coated and dried to a thickness of 60 nm as an electroluminescent adhesive layer 19 (Fig. 15).

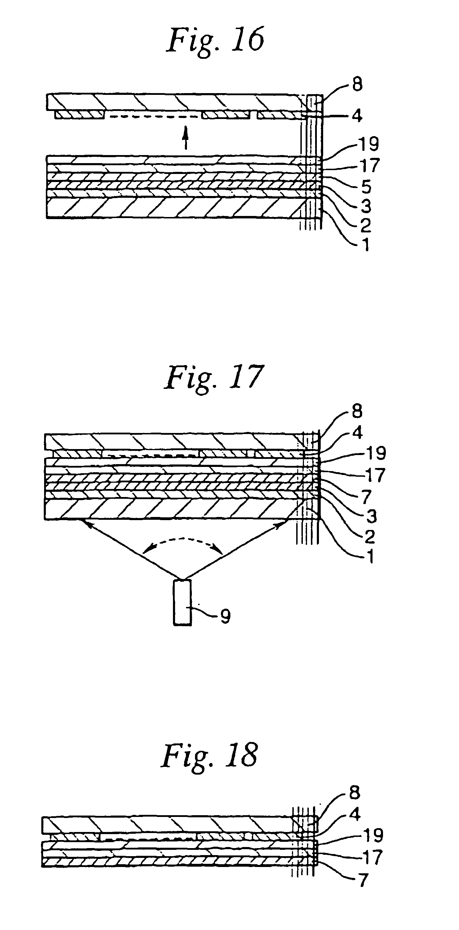

The resulting film was then placed in contact with a transparent glass substrate 8 having an aluminum and lithium alloy cathode 4 patterned with 256 stripes by laser (Fig. 16).

A pattern of 64 stripes was then produced with a 13 W YAG laser 9 on the film side so as to intersect the striped pattern of the ITO (Fig. 17).

The film was then removed, giving the organic EL substrate with 256 x 64 picture elements having the structure depicted in Fig. 18.

Drivers and a controller were then connected to the organic EL substrate, as shown in Fig. 7, a transparent protective substrate was placed in contact with a UV setting sealant, and the protective substrate was dured and sealed at room temperature by being irradiated with UV rays from behind. Moving image display could thus be achieved with the input of drive power and signals to the display device thus obtained. The luminous efficiency was 3.51 m/W.

The same materials and methods given in Embodiment 1 can be used in this embodiment as well.

### Embodiment 6

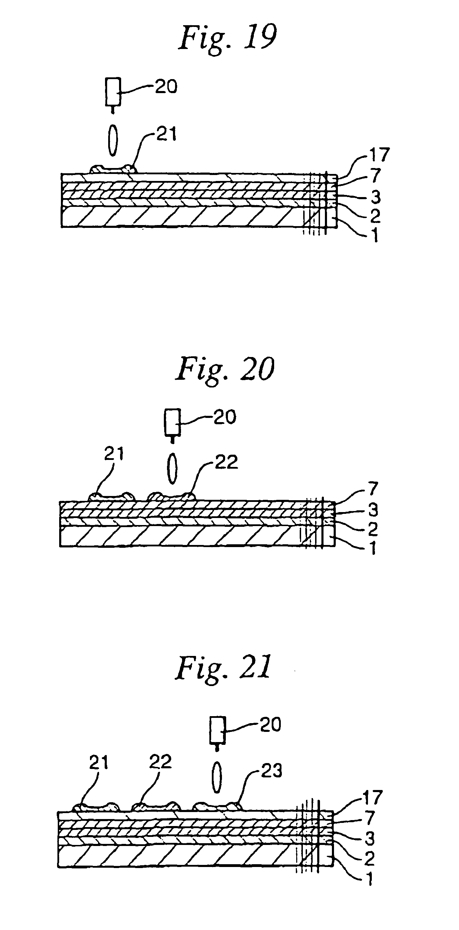

This embodiment is an example of luminescent substances emitting red, green, and blue light, which are dissolved and applied using an ink jet head to form the aforementioned light emitting layer during the formation of the light emitting layer in Embodiment 4. Figs. 19 through 25 are simple cross sections depicting the method for manufacturing the organic EL display device in the present invention.

Layers were first prepared in the same manner as in Embodiment 4 up to the formation of the cathode on the film.

Then, as shown in Fig. 19, a xylene solution of MEH-PPV was applied and dried in the form of a stripe by an ink jet head 20 to form a red-light emitting layer 21. Then, as shown in Fig. 20, a xylene solution of PPV was applied and dried in the form of a stripe by the ink jet head form a green light emitting layer 22 next to the above layer. Then, as shown in Fig. 21, a xylene solution of a fluorene compound 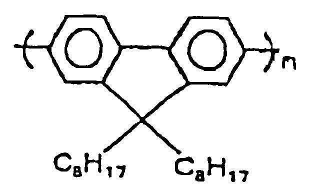 was applied and dried in the form of a stripe by the ink jet head to form a blue light emitting layer 23 between the aforementioned MEH-PPV and PPV derivatives

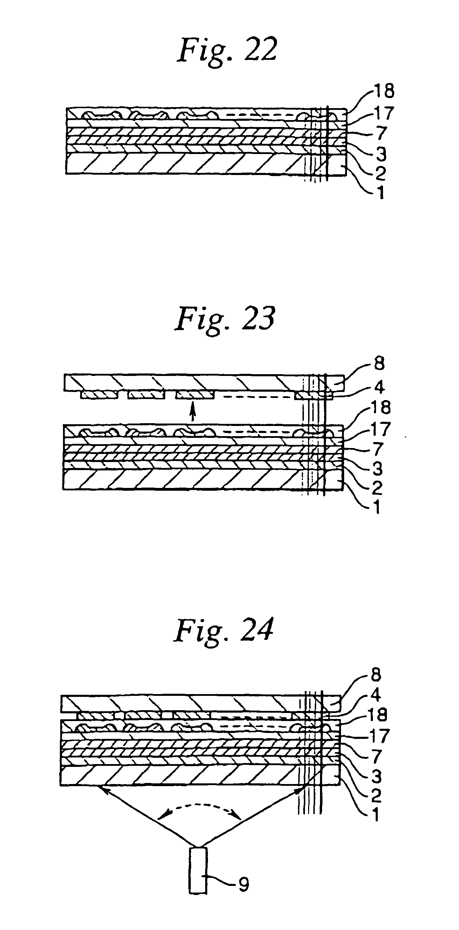

Then, PPV was dissolved in solvent and was coated and dried to a thickness of 60 nm an electron-injecting adhesive layer 18 (Fig. 22).

The resulting film was then placed in contact with a transparent glass substrate 8 having an aluminum and lithium alloy cathode 4 patterned with 256 stripes by laser, where the stripes of the light emitting layers were aligned with the stripes of the cathode (Fig. 23).

A pattern of 64 stripes was then produced with a YAG laser 7 on the film side so as to intersect the striped pattern of the cathode 2 (Fig. 24).

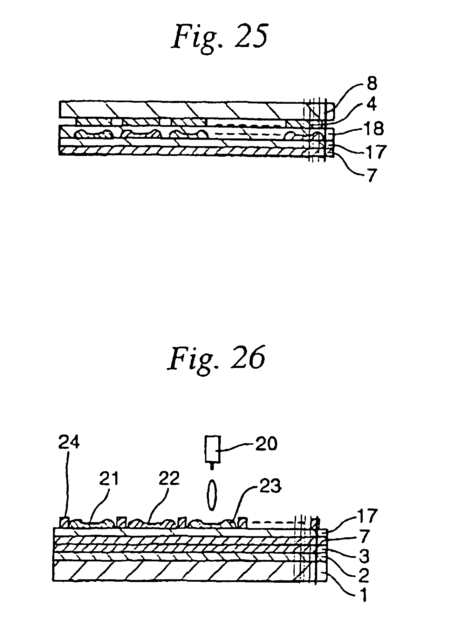

The film was then removed, giving the organic EL substrate with 256 x 64 picture elements having the structure depicted in Fig. 25.

Drivers and a controller were then connected to the organic EL substrate, as shown in Fig. 7, a transparent protective substrate was placed in contact with an epoxy thermosetting sealant to the anode, and moving image display could be achieved with the input of drive power and signals.

The same materials and manufacturing conditions given in Embodiment 4 can be used in this embodiment as well.

This embodiment was carried out with the structure given in Embodiment 4, but it can similarly be applied in the preparation of the light emitting layers or electroluminescent adhesive layers in the other embodiments.

### Embodiment 7

This embodiment is an example of the formation of partition walls in the light emitting layer prior to the formation of the cathode on the film. As shown in Fig. 26, partition walls 24 were printed in the widthwise direction between the colored light emitting layers by means of screen printing using thermosetting polyimide, and were heated and cured on the film used in Embodiment 5. An organic EL display device was then obtained in the same manner as in Embodiment 6.

The use of the resulting display device for color display allowed extremely bright display to be achieved without any color confusion.

The materials and methods used to form partition walls are not limited to those given here. Any other material and method capable of manufacturing the structure depicted in Fig. 26 can be used.

Although a partition wall structure was used as the element means between the colored light emitting layers here, ink may also be applied between picture elements following the formation of the electrode.

### INDUSTRIAL APPLICABILITY

Although it has been extremely difficult to pattern chemically unstable cathodes in the past, the present application allows such cathodes to be readily patterned. The elemental structure can be the reverse of conventional structures, making it possible to suppress the loss of light that is caused by the effects of moving light when emitted light passes through a glass substrate. An organic EL display with high luminous efficiency can thus be inexpensively produced by a simple method.

## Claims

1. A method for manufacturing an organic EL display device having at least a first electrode, a second electrode, and a light emitting layer provided between said first electrode and said second electrode, wherein said method is **characterized by** comprising the steps of:
forming a light-heat conversion layer and a heat-propagating layer on a film;
forming said first electrode on said heat-propagating layer;
applying a light emitting material dissolved in a solvent to said first electrode to form said light emitting layer;
placing said film with multiple layers, including at least said first electrode and said light-emitting layer, formed thereon, in contact with a substrate with said second electrode formed thereon, irradiating the other side of said film with a laser and then transferring said multiple layers from said film onto said substrate.

2. The method for manufacturing an organic EL display device according to Claim 1, **characterized in that** said light emitting layer is a bonding layer for bonding said first electrode and said multiple layers.

3. The method for manufacturing an organic EL display device according to Claim 1, **characterized in that** said first electrode is a cathode, and said second electrode is an anode.

4. The method for manufacturing an organic EL display device according to Claim 3, **characterized in that** said multiple layers further include a positive hole-injecting layer,
said positive hole-injecting layer is a bonding layer for bonding said anode and said multiple layer, and
said positive hole-injecting layer is formed between said light emitting layer and said anode.

5. The method for manufacturing an organic EL display device according to Claim 1, **characterized in that** said first electrode is an anode, and said second electrode is a cathode.

6. The method for manufacturing an organic EL display device according to Claim 5, **characterized in that** said multiple layers further include a positive hole-injecting layer,
said positive hole injecting layer is a bonding layer for bonding said enode layer and said multiple layers, and
said positive hole-injecting layer is formed between said light emitting layer and said anode.

7. The method for manufacturing an organic EL display device according to any one of Claims 1 to 6, **characterized in that** said light emitting layer is formed on said first electrode by applying luminescent substances emitting different-colored light by means of an ink jet head.

8. The method for manufacturing an organic EL display device according to Claim 7, **characterized in that** means for ink separation is provided between color regions before the application of said luminescent substances by means of an ink Jet heed.

## Patentansprüche

1. Verfahren zur Herstellung einer organischen Elektrolumineszenzanzeige mit mindestens einer ersten Elektrode, einer zweiten Elektrode und einer Lichtemissionsschicht, die zwischen der ersten Elektrode und der zweite Elektrode bereitgestellt ist, wobei das Verfahren **dadurch gekennzeichnet ist, dass** es die folgenden Schritte umfasst:
Bilden einer Licht/Wärme-Umwandlungsschicht und einer Wärmeausbreitungsschicht auf einem Film;
Bilden der ersten Elektrode auf der Wärmeausbreitungsschicht;
Auftragen eines Lichtemissionsmaterials, das in einem Lösemittel gelöst ist, auf die erste Elektrode zur Bildung der Lichtemissionsschicht;
Anordnen des Films mit mehreren Schichten, einschließlich mindestens der ersten Elektrode und der darauf gebildeten Lichtemissionsschicht, in Kontakt mit einem Substrat, auf dem die zweite Elektrode gebildet ist, Bestrahlen der anderen Seite des Films mit einem Laser und anschließendes Übertragen der mehreren Schichten von dem Film auf das Substrat.

2. Verfahren zur Herstellung einer organischen Elektrolumineszenzanzeige nach Anspruch 1, **dadurch gekennzeichnet, dass** die Lichtemissionsschicht eine Bindungsschicht zum Binden der ersten Elektrode und der mehreren Schichten ist.

3. Verfahren zur Herstellung einer organischen Elektrolumineszenzanzeige nach Anspruch 1, **dadurch gekennzeichnet, dass** die erste Elektrode eine Kathode ist und die zweite Elektrode eine Anode ist.

4. Verfahren zur Herstellung einer organischen Elektrolumineszenzanzeige nach Anspruch 3, **dadurch gekennzeichnet, dass** die mehreren Schichten des Weiteren eine positive Lochinjektionsschicht enthalten,
wobei die positive Lochinjektionsschicht eine Bindungsschicht zum Binden der Anode und der mehreren Schichten ist, und
die positive Lochinjektionsschicht zwischen der Lichtemissionsschicht und der Anode gebildet ist.

5. Verfahren zur Herstellung einer organischen Elektrolumineszenzanzeige nach Anspruch 1, **dadurch gekennzeichnet, dass** die erste Elektrode eine Anode ist und die zweite Elektrode eine Kathode ist.

6. Verfahren zur Herstellung einer organischen Elektrolumineszenzanzeige nach Anspruch 5, **dadurch gekennzeichnet, dass** die mehreren Schichten des Weiteren eine positive Lochinjektionsschicht enthalten,
wobei die positive Lochinjektionsschicht eine Bindungsschicht zum Binden der Anodenschicht und der mehreren Schichten ist, und
die positive Lochinjektionsschicht zwischen der Lichtemissionsschicht und der Anode gebildet ist.

7. Verfahren zur Herstellung einer organischen Elektrolumineszenzanzeige nach einem der Ansprüche 1 bis 6, **dadurch gekennzeichnet, dass** die Lichtemissionsschicht auf der ersten Elektrode durch Auftragen lumineszenter Substanzen, die verschieden farbiges Licht emittieren, mit Hilfe eines Tintenstrahlkopfs gebildet wird.

8. Verfahren zur Herstellung einer organischen Elektrolumineszenzanzeige nach Anspruch 7, **dadurch gekennzeichnet, dass** ein Mittel zur Tintentrennung zwischen Farbregionen vor dem Auftragen der lumineszenten Substanzen mit Hilfe eines Tintenstrahlkopfs bereitgestellt wird.

## Revendications

1. Procédé de fabrication d'un dispositif d'affichage électroluminescent organique possédant au moins une première électrode, une deuxième électrode, et une couche d'émission de lumière fournie entre ladite première électrode et ladite deuxième électrode, ledit procédé se caractérisant en qu'il comprenne les étapes suivantes :
formation d'une couche de conversion de lumière-chaleur et d'une couche de propagation de chaleur sur une pellicule ;
formation de ladite première électrode sur ladite couche de propagation de chaleur ;
application d'une matière d'émission de lumière dissoute dans un solvant sur ladite première électrode afin de former ladite couche d'émission de lumière ;
mise en place de ladite pellicule à couches multiples, incluant au moins ladite première électrode et ladite couche d'émission de lumière formées dessus, en contact avec un substrat avec ladite deuxième électrode formée dessus, irradiation de l'autre côté de ladite pellicule avec un laser, et ensuite transfert desdites couches multiples de ladite pellicule sur ledit substrat.

2. Procédé de fabrication d'un dispositif d'affichage électroluminescent organique selon la revendication 1, **caractérisé en ce que** ladite couche d'émission de lumière est une couche de liaison pour lier ladite première électrode et lesdites couches multiples.

3. Procédé de fabrication d'un dispositif d'affichage électroluminescent organique selon la revendication 1, **caractérisé en ce que** ladite première électrode est une cathode, et **en ce que** ladite deuxième électrode est une anode.

4. Procédé de fabrication d'un dispositif d'affichage électroluminescent organique selon la revendication 3, **caractérisé en ce que** lesdites couches multiples comprennent par ailleurs une couche à injection de trous positive,
ladite couche à injection de trous positive étant une couche de liaison pour lier ladite anode et ladite couche multiple, et
ladite couche à injection de trous positive étant formée entre ladite couche d'émission de lumière et ladite anode.

5. Procédé de fabrication d'un dispositif d'affichage électroluminescent organique selon la revendication 1, **caractérisé en ce que** ladite première électrode est une anode, et **en ce que** ladite deuxième électrode est une cathode.

6. Procédé de fabrication d'un dispositif d'affichage électroluminescent organique selon la revendication 5, **caractérisé en ce que** lesdites couches multiples comprennent par ailleurs une couche à injection de trous positive,
ladite couche à injection de trous positive étant une couche de liaison pour lier ladite couche d'anode et lesdites couches multiples, et
ladite couche à injection de trous positive étant formée entre ladite couche d'émission de lumière et ladite anode.

7. Procédé de fabrication d'un dispositif d'affichage électroluminescent organique selon l'une quelconque des revendications 1 à 6, **caractérisé en ce que** ladite couche d'émission de lumière est formée sur ladite première électrode en appliquant des substances luminescentes émettant une lumière à couleurs différentes à l'aide d'une tête à jet d'encre.

8. Procédé de fabrication d'un dispositif d'affichage électroluminescent organique selon la revendication 7, **caractérisé en ce qu'**un moyen pour la séparation de l'encre est fournit entre des zones colorées avant l'application desdites substances luminescentes à l'aide d'une tête à jet d'encre.
